Europäisches Patentamt

European Patent Office

Office européen des brevets

(19)

(11) Veröffentlichungsnummer: **0 015 905**
**B2**

(12) **NEUE EUROPÄISCHE PATENTSCHRIFT**

(45) Veröffentlichungstag der neuen Patentschrift:
**12.04.89**

(51) Int. Cl.⁴: **H 01 F 40/08, H 01 G 4/00**

(21) Anmeldenummer: **79900114.4**

(22) Anmeldetag: **23.01.79**

(86) Internationale Anmeldenummer:
**PCT/CH 79/00005**

(87) Internationale Veröffentlichungsnummer:
**WO 79/00729 (04.10.79 Gazette 79/20)**

(54) **KOMBINIERTER STROM- UND SPANNUNGSWANDLER FÜR EINE DRUCKGASISOLIERTE METALLGEKAPSELTE HOCHSPANNUNGSANLAGE.**

(30) Priorität: **09.03.78 CH 2554/78**

(43) Veröffentlichungstag der Anmeldung:
**01.10.80 Patentblatt 80/20**

(45) Bekanntmachung des Hinweises auf die Patenterteilung:
**12.05.82 Patentblatt 82/19**

(45) Bekanntmachung des Hinweises auf die Entscheidung
über den Einspruch:
**12.04.89 Patentblatt 89/15**

(84) Benannte Vertragsstaaten:
**DE FR GB SE**

(56) Entgegenhaltungen:
**CH-A- 514 923**
**FR-A- 2 108 875**

(73) Patentinhaber: **BBC Brown Boveri AG, Haselstrasse,
CH-5401 Baden (CH)**

(72) Erfinder: **HARTMANN, Hans, Im Holzerhurd 43/62,
CH-8046 Zürich (CH)**
Erfinder: **MAUTHE, Gerhard, Oberhardhalde 558,
CH-5413 Birmenstorf (CH)**

## Beschreibung

Die Erfindung bezieht sich auf einen kombinierten Strom- und Spannungswandler für eine druckgasisolierte metallgekapselte Hochspannungsanlage gemäss dem Oberbegriff des Anspruchs 1.

Es ist bekannt, bei Spannungswandlern für eine gekapselte Hochspannungsanlage, welche mit Druckgas, z. B. $SF_6$, gefüllt ist, die Messspannung mittels kapazitiver Spannungsteilung zu gewinnen (DE-A 2 139 225). Ferner ist es auch bekannt (DE-A 2 325 441), durch zusätzliche Anordnung von bewickelten Stromwandlerkernen einen kombinierten Strom- und Spannungswandler zu schaffen. Diesen Wandlern ist gemeinsam, dass die der Spannungsmessung dienende Elektrode und auch die allfälligen Stromwandlerkerne innerhalb der Kapselung angeordnet sind, so dass isolierende Durchführungen erforderlich sind, um die sekundären Anschlüsse nach ausserhalb der Kapselung zu führen. Bei ungenügender Trocknung der Stromwandlerkerne besteht ausserdem die Gefahr, dass das $SF_6$-Gas feucht wird.

Aus dem DE-GM 7 407 268 ist ein Wandler bekanntgeworden, bei dem zwar der Stromwandlerkern ausserhalb der $SF_6$-Gasfüllung angeordnet ist, aber bei dem sich der eine Metallbelag, der die eine Elektrode für die kapazitive Spannungsteilung bildet, immer noch innerhalb der Kapselung befindet, so dass dafür eine Durchführung durch die Kapselung erforderlich ist. Ferner ist das den Metallbelag tragende Zwischenstück ein Isolierrohr, das dem in der Kapselung herrschenden Innendruck ausgesetzt ist.

Aus Patentanspruch 6 und Fig. 1 der DE-A 2 409 990 ist ein Wandler gemäss dem Oberbegriff des Patentanspruchs 1 bekannt, bei dem Stromwandlerkerne auf einem als Isolierrohr ausgebildeten Tragkörper zwischen zwei Flanschen einer Hochspannungsanlage angeordnet sind. Auf dem Isolierrohr sind stirnseitig Dichtungsringe vorgesehen, welche beim Verspannen der Flansche mittels Schrauben den Innenraum der Hochspannungsanlage abdichten. Diese Schrauben bewirken zugleich die galvanische Verbindung der beiden Flansche. Auf Ober- und Unterseite des Isolierrohrs sind leitende Beläge vorgesehen, welche zusammen mit dem Innenleiter der Hochspannungsanlage einen kapazitiven Spannungswandler bilden, welcher zur Spannungsmessung vorgesehen ist.

Bei einem solchen Wandler müssen vom Isolierrohr grosse mechanische Belastungen aufgenommen werden, da der Innenraum der Hochspannungsanlage mit einem Isoliergas von mehreren bar Druck gefüllt ist, und die Wandlerkerne ein erhebliches Gewicht aufweisen. Ferner ist die durch die Schrauben bewirkte galvanische Verbindung zwischen den beiden Flanschen nur unzureichend und erschweren diese Schrauben darüber hinaus den Zugang zu den Wandlerkernen.

Hier will die Erfindung Abhilfe schaffen. Die Erfindung, wie sie in den Ansprüchen gekennzeichnet ist, löst die Aufgabe, einen kombinierten Strom- und Spannungswandler für eine druckgasgefüllte gekapselte Hochspannungsanlage zu schaffen, bei dem auch bei einer grösseren Anzahl von Wandlerkernen etwaige mechanische Schwachstellen der Anlage mit Sicherheit vermieden und gleichzeitig mit einfachen Mitteln eine Führung des Kapselungsstromes erreicht wird, ohne dass eine verfälschende Beeinflussung des Messstromes möglich ist.

Die mit der Erfindung erreichten Vorteile sind im wesentlichen darin zu sehen, dass der Tragkörper grossen mechanischen Belastungen ausgesetzt werden kann, ohne dass er durch zusätzliche Mittel, wie etwa parallelgeführte Verschraubungen, entlastet werden muss. Bei Wartungs- und Montagearbeiten ist daher der freie Zugang zu den Wandlerkernen gegeben, ohne vorher Mittel, wie Verschraubungen, entfernen zu müssen, welche die Dichtung der Anlage bewirken. Darüber hinaus können die Wandlerkerne in einem mechanisch geschützten Raum untergebracht werden, dessen Aussenwand neben der Schutzfunktion gleichzeitig die Funktion der Führung des Kapselungsstromes erfüllt.

In der Zeichnung ist ein Ausführungsbeispiel der Erfindung wiedergegeben. Es zeigt

Fig. 1 einen Schnitt des Kombiwandlers und
Fig. 2 das Detail A in Fig. 1 im vergrösserten Massstab, während
Fig. 3 eine Variante bezüglich des zum Spannungs-Messverstärkers hinführenden Messkabels wiedergibt.

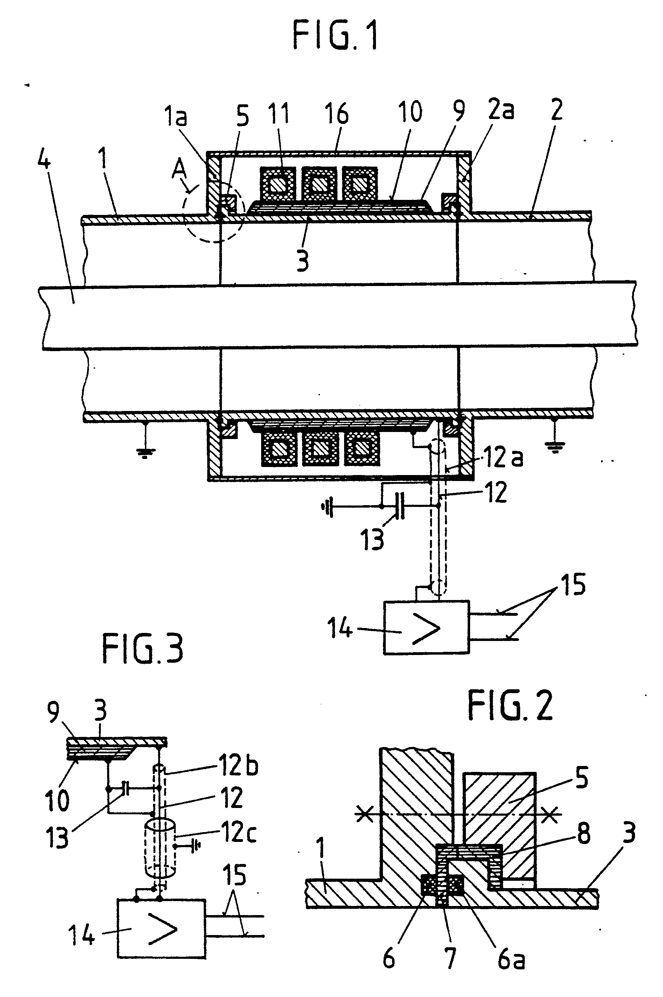

In Fig. 1 befindet sich zwischen der Kapselung 1, 2 das isoliert eingesetzte Zwischenteil 3, welches praktisch gleichen Innendurchmesser sowie Wandstärke wie die Kapselung aufweist. Die Teile 1 bis 3 bestehen zweckmässig aus Leichtmetall wie Aluminium oder einer Legierung davon. Mit 4 ist der innerhalb der Kapselung 1, 2 in bekannter Weise isoliert gehalterte hochspannungsführende Stromleiter bezeichnet. Das Kapselinnere ist mit Druckgas z. B. $SF_6$ gefüllt. Aus der Fig. 2, welche das Detail A der Fig. 1 im vergrösserten Massstab zeigt, geht die Verbindung des Zwischenteils 3 mit der Kapselung 1 deutlicher hervor. Zwischen der Kapselung 1 und dem Zwischenteil 3 sind die Isolierteile 7, 8 angeordnet, wobei das Isolierteil 8 den Druckring 5 gegen das Zwischenteil 3 isoliert. Der Druckring 5 und die Kapselung 1 sind mittels symbolisch angedeuteter Verschraubungen miteinander verflanscht. Wenn der Druckring 5 statt aus Metall aus einem verstärkten isolierenden Kunststoff besteht, kann das Isolierteil 8 gegebenenfalls zwecks Vereinfachung der Konstruktion entfallen. Eine weitere Vereinfachung lässt sich erzielen, wenn man das Isolierteil 7 und die ihm anliegenden Dichtungen 6, 6a als ein Stück herstellt. Vorzugsweise sind die Isolierteile hierbei als Pressformteile aus einem Kunststoff mit guten mechanischen und elektrischen Eigenschaften hergestellt. Das Zwischenteil 3 besitzt auf seiner Aussenseite die Isolierstoffbeschichtung 9. Letztere wird aus dünner Kunststoffolie mit guten elektrischen Eigenschaften auf das Zwischenteil 3 in an sich bekannter Weise aufgewickelt. Der Metallbelag 10 wird seinerseits wiederum auf der Aussenseite der Isolierbeschichtung 9 aufgebracht. Vorzugsweise kann er aus einem im Wandlerbau vielfach verwendeten Kupfergewebe bestehen, welches mit Klebstoff bestrichen und auf die Isolierbeschichtung aufgewickelt ist. Die Teile 3, 9, 10 dienen als Tragkörper für die bewickelten Stromwandlerkerne 11. Letztere sind auf dem Metallbelag 10 unter Verwendung nicht näher dargestellter isolierender Zwischenlagen mittels zusätzlicher Bandagen fixiert und mit einer lufthärtenden Spachtelmasse befestigt. Die Länge der Teile 3, 9, 10 wird zweckmässig so bemessen, dass eine grössere Anzahl, beispielsweise fünf, von Stromwandlerkernen 11 untergebracht werden kann. Hierbei können Mess- und Schutzkerne mit verschiedener Leistung und Klassengenauigkeit, wodurch sich unterschiedliche Kernlängen ergeben, in Betracht kommen. Durch das die Kapselung 1, 2 leitend verbindende metallische Mantelrohr 16 sind die Stromwandlerkerne 11 einerseits mechanisch geschützt und andererseits ist dadurch gesorgt, dass die in der Kapselung 1, 2 fliessenden Kapselungsströme keine verfälschende Wirkung auf den Messstrom ausüben.

Während sich beim Spannungswandlerteil die Oberspannungskapazität durch die natürliche Kapazität zwischen Stromleiter 4 und Zwischenteil 3 ergibt, setzt sich die Unterspannungskapazität aus mehreren Teilkapazitäten zusammen. Es sind dies: die Kapazität zwischen den Teilen 3 und 10, diejenige des Messkabels 12, 12a und des Zusatzkondensators 13 sowie gegebenenfalls diejenige zwischen den Teilen 3 und 5/1/1a. Mit dem Zusatzkondensator kann die je nach Aufstellungsort des kapazitiven Teilers und des Messverstärkers unterschiedliche Länge des Messkabels hinsichtlich seiner damit auch unterschiedlichen Kapazität ausgeglichen werden. Dadurch und durch Auswahl eines bestimmten Temperaturkoeffizienten des Zusatzkondensators 13 kann für das Verhältnis Ober- zu Unterspannungskapazität über einen grossen Temperaturbereich eine grosse Genauigkeit erreicht werden. In Fig. 1 ist das abgeschirmte Messkabel 12/12a einadrig. Seine Abschirmung 12a ist an den Metallbelag 10 und an das eine Ende des Zusatzkondensators 13 angeschlossen und überdies geerdet. In Fig. 3 ist das abgeschirmte Messkabel 12/12b/12c zweiadrig. Dadurch ergibt sich die Möglichkeit, die Ader 12b isoliert in den Messverstärker 14 einzuführen. Als elektronischer Messverstärker können solche handelsüblicher Bauart verwendet werden. Ihr Ausgang ist mit 15 angedeutet. Dem Zusatzkondensator 13 kann zu seinem Schutz ein Überspannungsschutzgerät (nicht dargestellt) zugeordnet werden. Bei der Anordnung nach Fig. 3 kann der Zusatzkondensator 13 und die Kapazität zwischen den Teilen 3 und 10 in den Rückkopplungskreis des Messverstärkers 14 einbezogen werden.

## Patentansprüche

1. Kombinierter Strom- und Spannungswandler für eine druckgasisolierte metallgekapselte Hochspannungsanlage mit

- einem gasdicht zwischen zwei metallischen Flanschen (1a, 2a) der Kapselung (1, 2) eingesetzten rohrförmigen Zwischenteil (3),
- mindestens einem bewickelten und auf einem Tragkörper, der das Zwischenteil (3) enthält, gehaltenen Ringkern (11) des Stromwandlers,
- einem das Zwischenteil (3) der Kapselung (1, 2) und den mindestens einen Ringkern (11) umschliessenden und auf den Flanschen (1a, 2a) der Kapselung (1, 2) aufliegenden Mantelrohr (16), und
- einer elektrisch leitenden Verbindung zwischen den beiden Flanschen (1a, 2a) zur Führung des in der Kapselung (1, 2) fliessenden Stroms, wobei
- Aussen- und Innenseite des Tragkörpers von elektrisch leitenden und gegeneinander elektrisch isolierten Teilen gebildet und jeweils über eine Verbindungsleitung Eingängen eines Messverstärkers (14) zugeführt sind, und
- das die Innenseite bildende Teil mit einem Stromleiter (4) der Anlage den Ober- und mit einem die Aussenseite bildenden Metallbelag (10) eine Teilkapazität des Unterspannungskondensators des Spannungswandlers bildet, dadurch gekennzeichnet,
- dass das ganze Zwischenteil (3) aus dem Material der Kapselung (1, 2) besteht und als das die Innenseite bildende elektrisch leitende Teil des Tragkörpers ausgebildet ist,
- dass das Zwischenteil (3) unter Zwischenlage von Isolierteilen (7, 8) elektrisch isoliert zwischen den Flanschen (1a, 2a) eingesetzt und mittels je eines Druckringes (5) mit den Flanschen (1a, 2a) der Kapselung (1, 2) verschraubt ist,
- dass auf der Aussenseite des Zwischenteils (3) eine aus Kunststoffolie gewickelte Isolierstoffbeschichtung (9) aufgebracht ist,
- dass auf der Aussenseite der Isolierstoffbeschichtung (9) der Metallbelag (10) aufgebracht ist, und
- dass das Mantelrohr (16) metallisch ist und der elektrisch leitenden Verbindung der Flansche (1a, 2a) zur Führung des Kapselungsstromes dient.

2. Wandler nach Anspruch 1, dadurch gekennzeichnet, dass das Zwischenteil (3) und ein auf der Aussenseite der Isolierstoffbeschichtung (9) aufgebrachter Metallbelag (10) über ein abgeschirmtes Messkabel (12, 12a; 12, 12b, 12c) mit dem Eingang eines Messverstärkers (14) verbunden sind, und dass dem aus Zwischenteil (3) und Metallbelag (10) gebildeten Unterspannungskondensator eine Zusatzkapazität (13) parallel geschaltet ist.

## Revendications

1. Transformateur de courant et de tension combiné pour une installation de haute tension enfermée dans une enveloppe métallique remplie de gaz isolant sous pression avec
- une pièce intermédiaire tubulaire (3) disposée hermétiquement entre deux flasques métalliques (1a, 2a) de l'enveloppe (1, 2),
- au moins un rotor annulaire (11) du transformateur de courant, bobiné et maintenu sur un support qui contient la pièce intermédiaire (3),
- un tube extérieur (16) entourant la pièce intermédiaire (3) de l'enveloppe (1, 2) et le ou les rotor (s) annulaire (s) (11) et appliqué sur les flasques (1a, 2a) de l'enveloppe (1, 2), et
- une liaison électriquement conductrice entre les deux flasques (1a, 2a) pour conduire le courant circulant dans l'enveloppe (1, 2),
    dans lequel
- les faces extérieure et intérieure du support sont constituées de pièces électriquement conductrices et isolées électriquement l'une par rapport à l'autre et sont chacune reliées par un raccordement propre à des entrées d'un amplificateur de mesure (14), et
- la pièce constituant la face intérieure forme avec un conducteur de courant (4) de l'installation le condensateur haute tension du transformateur de tension et avec un recouvrement métallique (10), formant la face extérieure, une capacité partielle du condensateur basse tension du transformateur de tension,
    caractérisé en ce que
- la pièce intermédiaire (3) est réalisée entièrement dans le matériau de l'enveloppe (1, 2) et elle est constituée comme la pièce électriquement conductrice du support qui forme la face intérieure,
- la pièce intermédiaire (3) est disposée en position électriquement isolée entre les flasques (1a, 2a) par interposition de pièces d'isolation (7, 8) et elle est serrée par vissage au moyen de bagues de pression (5) à chacun des flasques (1a, 2a) de l'enveloppe (1, 2),
- sur la face extérieure de la pièce intermédiaire (3) est posé un recouvrement en matériau isolant (9) par enroulement d'une feuille de matière plastique,
- sur la face extérieure du recouvrement en matériau isolant (9) est posé le recouvrement métallique (10), et
- le tube extérieur (16) est métallique et sert de liaison électriquement conductrice entre les flasques (1a, 2a) pour conduire le courant de l'enveloppe.

2. Transformateur suivant la revendication 1, caractérisé en ce que la pièce intermédiaire (3) et un recouvrement métallique (10) déposé sur la face extérieure du recouvrement en matériau isolant (9) sont raccordés par un câble de mesure blindé (12, 12a ; 12, 12b, 12c) à l'entrée d'un amplificateur de mesure (14), et en ce qu'un condensateur auxiliaire (14) est monté en parallèle sur le condensateur basse tension formé par la pièce intermédiaire (3) et le recouvrement métallique (10).

## Claims

1. Combined current and voltage transformers for a high voltage installation enclosed in a metal envelope filled with pressure gas, comprising
- a tubular intermediate section (3) inserted gas tight between two metallic flanges (1a, 2a) of the enclosure (1, 2),
- at least one toroidal core (11), which is wound and held on a support body which contains the intermediate section (3), of the current transformer,
- a jacket tube (16) which encloses the intermediate section (3) of the enclosure (1, 2) and the at least one toroidal core (11) and rests on the flanges (1a, 2a) of the enclosure (1, 2), and
- an electrically conductive connection between the two flanges (1a, 2a) for carrying the current flowing in the enclosure (1, 2), in which arrangement
- outside and inside of the support body are formed by electrically conductive and mutually electrically insulated parts and are in each case connected via a connecting line to inputs of a measurement amplifier (14), and
- the part forming the inside forms with a current conductor (4) of the installation the high-voltage capacitor and with a metal coating (10) forming the outside part-capacitance of the low-voltage capacitor of the voltage transformer,
    characterized in
- that the entire intere intermediate section (3) consists of the material of the enclosure (1, 2) and is constructed as the electrically conductive part of the support body forming the inside,
- that the intermediate section (3) is inserted with interposition of insulating parts (7, 8) electrically insulated between the flanges (1a, 2a) and is screwed by means of one pressure ring (5) each to the flanges (1a, 2a) of the enclosure (1, 2),
- that an insulating material layer (9) wound from plastic foil is applied to the outside of the intermediate section (3),
- that the metal coating (10) is applied to the outside of the insulating material layer (9), and
- that the jacket tube (16) is metallic and is used for electrically conductively connecting the flanges (1a, 2a) for carrying the enclosure current.

2. Transformers according to Claim 1, characterized in that the intermediate section (3) and a metal coating (10) applied to the outside of the insulating material layer (9) are connected via a shielded measuring cable (12, 12a ; 12, 12b, 12c) to the input of a measurement amplifier (14), and that an additional capacitance (13) is connected in parallel with the low-voltage capacitor formed from intermediate section (3) and metal coating (10).

# FIG.1

# FIG.3

# FIG.2